# EUROPÄISCHE PATENTSCHRIFT

(11) **EP 3 416 854 B1**
(45) Veröffentlichungstag und Bekanntmachung des Hinweises auf die Patenterteilung: **11.12.2019**
(21) Anmeldenummer: 17701871.0
(22) Anmeldetag: 27.01.2017
(51) Int. Cl.: B60K 35/00, H05K 7/14, H05K 7/16, B60R 11/02, B60R 11/00, G06F 1/16

(54) **HALTER FÜR FLACHE, IN ETWA RECHTECKIGE GERÄTE WIE TABLET-COMPUTER ODER SMARTPHONES**
HOLDER FOR FLAT, APPROXIMATELY RECTANGULAR DEVICES SUCH AS TABLET COMPUTERS OR SMARTPHONES
SUPPORT POUR APPAREILS PLATS APPROXIMATIVEMENT RECTANGULAIRES, TELS QUE TABLETTES NUMÉRIQUES OU TÉLÉPHONES INTELLIGENTS

(30) Priorität: 15.02.2016 DE 102016102611; 31.10.2016 DE 102016120748
(43) Veröffentlichungstag der Anmeldung: 26.12.2018
(73) Patentinhaber: Kinetix AG, 7000 Chur (CH)
(72) Erfinder: MAISENBACHER, Michael, 75365 Calw (DE); SPANG, Peter, 72178 Waldachtal (DE); FUNK, Walter, 72226 Simmersfeld (DE); KELLER, Michael Andreas, 72250 Freudenstadt (DE)
(74) Vertreter: DREISS Patentanwälte PartG mbB
(86) Internationale Anmeldenummer: PCT/EP2017/051788
(87) Internationale Veröffentlichungsnummer: WO 2017/140474

(56) Entgegenhaltungen:
- EP-A1- 2 843 287
- WO-A1-2009/020254
- DE-U1-202015 101 259
- US-A1- 2011 049 321

## Beschreibung

Die Erfindung betrifft einen Halter mit den Merkmalen des Oberbegriffs des Patentanspruchs 1, gemäß DE 20 2015 101 259 U1.

Aus der EP 2 528 781 B1 bekannt ist ein Halter zur lösbaren Befestigung eines flachen, in etwa rechteckigen Geräts wie eines Tablet-Computers oder eines Smartphones an einem Bauteil, insbesondere an einem Bauteil eines Kraftfahrzeugs, wobei der Halter eine Halteeinrichtung zur lösbaren Halterung des Geräts und ein mit der Haltereinrichtung verbundenes Befestigungselement zur Verbindung des Halters mit dem Bauteil aufweist, wobei ein um eine Drehachse drehbares Drehlager vorgesehen ist, das mit der Haltereinrichtung verbunden ist und wobei ein mit dem Drehlager verbundenes Schwenklager vorgesehen sind, das mit dem Befestigungselement verbunden ist. Die Erfindung betrifft ferner eine Befestigungseinrichtung, die einen derartigen Halter umfasst.

Bei dem aus der EP 2 528 781 B1 bekannten Halter ist das Drehlager mit dem Schwenklager mittelbar über ein zweites Drehlager verbunden, wobei somit eine Art "Pleuellösung" realisiert werden kann, mittels derer der Halter bzw. das am Halter angeordnete Gerät zwischen zwei Gebrauchsstellungen verschwenkt werden kann. Dabei ist es denkbar, diesen Halter mittels eines dafür ausgebildeten Befestigungselements in einer Buchse eines Kraftfahrzeugs zu befestigen oder die Halter beispielsweise mittelbar mittels einer dafür vorgesehenen Befestigungseinrichtung an den Kopfstützenstangen eines Kraftfahrzeugs zu befestigen. Insbesondere bei großen Tablet-Computern der neueren Generation, die in der Draufsicht oftmals eine Größe aufweisen, welche die Fläche eines DIN-A4-Blatts übersteigt, haben sich diese Halter jedoch insbesondere bei einer Befestigung an den Kopfstützenstangen als teilweise nachteilig herausgestellt. Einerseits kann eine Stellung des Tablet-Computers in eine Hochformatstellung aufgrund der Nähe zum Fahrzeugdach bzw. Fahrzeughimmel aufgrund des "Pleuels" verhindert sein.

Andererseits weisen die neuartigen, besonders großen Tablet-Computer Displaygrößen von 13 Zoll und mehr auf. Diese Größe der Tablet-Computer wirkt sich auch auf die Masse der Tablet-Computer aus, welche ebenfalls ansteigt. In einem Crashfall ist dabei der lange Hebelarm des aus der EP 2 528 781 B1 bekannten Pleuels aufgrund der größeren Masse nachteilig.

Der Erfindung liegt daher die Aufgabe zugrunde, einen einfach herstellbaren Halter zur lösbaren Befestigung eines flachen, in etwa rechteckigen Geräts wie eines Tablet-Computers oder eines Smartphones an einem Bauteil, insbesondere an einem Bauteil eines Kraftfahrzeugs bereitzustellen, mit dem auch größere Tablet-Computer stabil und sicher befestigt werden können.

Diese Aufgabe wird bei einem Halter der eingangs genannten Art mit den kennzeichnenden Merkmalen des Anspruchs 1 gelöst. Vorteilhafte Weiterbildungen sind in den Unteransprüchen genannt.

Der erfindungsgemäße Halter zeichnet sich dadurch aus, dass eine Ringfeder vorgesehen ist, die derart ausgebildet und angeordnet ist, dass die Rastelemente mittels der Ringfeder nach radial innen in die Rastposition vorgespannt sind. Vorteilhafterweise gleiten der erste und der zweite Drehlagerabschnitt beim Verdrehen um das Drehlager aufeinander. Es ist dabei denkbar, dass die Ringfeder aus einem Federstahl ausgebildet ist. Es ist jedoch auch denkbar, dass die Ringfeder aus einem insbesondere federelastischen Kunststoff hergestellt ist. Vorteilhafterweise ist die Ringfeder radial, d.h. in einer Richtung senkrecht zur Drehachse des Drehlagers, außerhalb der Rastelemente angeordnet.

In einer ersten vorteilhaften Weiterbildung des Halters ist vorgesehen, dass die Halteeinrichtung eine Aufnahme für das Gerät und im Bereich der Aufnahme angeordnete Halteelemente zur Halterung des Geräts aufweist und dass der erste Drehlagerabschnitt auf der der Aufnahme abgewandten Seite der Halteeinrichtung angeordnet ist. Vorteilhafterweise ist der erste Drehlagerabschnitt direkt mit der Halteeinrichtung verbunden, ist jedoch in jedem Falle drehfest mit der Halteeinrichtung verbunden, bspw. verschraubt.

Vorteilhafterweise ist ein Verbindungselement vorgesehen, wobei der zweite Drehlagerabschnitt am Verbindungselement angeordnet ist und wobei das Verbindungselement Schwenklagerabschnitte des Schwenklagers aufweist. Dabei ist es ferner denkbar, dass am Befestigungselement Schwenklagergegenabschnitte vorgesehen sind, wobei die Schwenklagerabschnitte und die Schwenklagergegenabschnitte derart miteinander korrespondieren, dass das Schwenklager als Reiblager ausgebildet ist.

Weiterhin ist es vorteilhaft, wenn der erste Drehlagerabschnitt als Konus ausgebildet ist, wobei der zweite Drehlagerabschnitt als Gegenkonus ausgebildet ist. Als besonders vorteilhaft hat es sich dabei erwiesen, wenn der Konus und der Gegenkonus gegenüber der Drehachse des Drehlagers einen identischen Neigungswinkel aufweisen und koaxial zueinander angeordnet sind, so dass der Konus und der Gegenkonus zur Realisierung des Drehlagers beim Verdrehen aufeinander abgleiten können.

Um eine Verstellung eines Tablet-Computers oder eines Smartphones vom Hoch- ins Querformat oder umgekehrt ermöglichen zu können und den Halter in der jeweiligen Position zu verrasten, hat es sich als besonders vorteilhaft erwiesen, wenn am ersten Drehlagerabschnitt mehrere, vorzugsweise 4 Rastnuten vorgesehen sind, die über den Umfang des ersten Drehlagerabschnitts in regelmäßigen Abständen zueinander angeordnet sind. Wenn 4 Rastnuten vorgesehen sind ist es besonders vorteilhaft, wenn die Rastnuten in einem Winkel von jeweils 90° zueinander angeordnet sind. Wenn 4 Rastnuten in einem Winkel von je 90° zueinander angeordnet sind ist lediglich eine Verstellung vom Hoch- ins Querformat möglich. Wenn mehr als 4 Rastnuten in kleineren Winkelabständen vorgesehen sind, kann auch eine Verrastung in Zwischenpositionen ermöglicht werden.

Gemäß einer besonders vorteilhaften Weiterbildung des Halters ist vorgesehen, dass die Rastelemente Rastabschnitte aufweisen, die mit den Rastnuten derart korrespondieren, dass die Rastabschnitte in der Rastposition zumindest teilweise in die Rastnuten eingerückt sind. So ist es beispielsweise denkbar, dass die Rastnuten ein Rastnutenprofil aufweisen, wobei die Rastabschnitte ein Rastabschnittprofil aufweisen, das einer Negativform des Rastnutenprofils entspricht.

Als besonders vorteilhaft hat es sich dabei erwiesen, wenn die Rastnuten und die Rastabschnitte ein Profil aufweisen, das derart ausgebildet ist, dass ein Verdrehen des ersten Drehlagerabschnitts gegenüber dem zweiten Drehlagerabschnitt zu einer Verlagerung der Rastelemente von der Rastposition in die Freigabeposition entgegen der Federkraft der Ringfeder führt. Gemäß einer vorteilhaften Weiterbildung des Halters sind die Rastnuten als V-Nuten ausgebildet, wobei die Rastelemente mit den V-Nuten korrespondierende V-förmige Rastabschnitte aufweisen. Ein Verdrehen des ersten Drehlagerabschnitts gegenüber dem zweiten Drehlagerabschnitt führt somit zu einem Abgleiten der V-Nuten und der V-förmigen Rastabschnitte aufeinander in Umfangsrichtung. Durch dieses Abgleiten in Umfangsrichtung werden die V-förmigen Rastabschnitte entgegen der Federkraft der Ringfeder nach radial außen (d.h. senkrecht zur Drehachse des Drehlagers) gedrängt und geben somit die Rastnuten wieder frei, so dass die Rastelemente von der Rastposition in die Freigabeposition bewegt werden.

In einer besonders kostengünstigen und zugleich stabilen Ausführungsform des Halters sind mehrere, vorzugsweise 2 Rastelemente vorgesehen, die spiegelbildlich zur Drehachse angeordnet sind.

Als besonders vorteilhaft hat es sich dabei erwiesen, wenn am zweiten Drehlagerabschnitt mehrere, vorzugsweise 2 Führungsabschnitte für die Rastelemente vorgesehen sind, die spiegelbildlich zur Drehachse angeordnet sind. Vorteilhafterweise sind die Führungsabschnitte mit dem zweiten Drehlagerabschnitt drehfest verbunden bzw. sind in den zweiten Drehlagerabschnitt bspw. mittels eines Kunststoffspritzgussverfahrens eingegossen, wobei die Rastelemente in den Führungsabschnitten geführt sind. Aufgrund der drehfest mit dem zweiten Drehlagerabschnitt verbundenen Führungsabschnitte können die in den Führungsabschnitten geführten Rastelemente zur Verrastung mit dem ersten Drehlagerabschnitt in die Rastnuten derart einrücken, dass der ersten Drehlagerabschnitt gegenüber dem zweiten Drehlagerabschnitt fixiert ist.

Um die Rastelemente besonders sicher führen zu können hat es sich als vorteilhaft erwiesen, wenn die Führungsabschnitte zur Führung der Rastelemente ausgelegt sind. Dabei ist es denkbar, dass ein Innenprofil der Führungsabschnitte senkrecht zur Drehachse mit einem Außenprofil der Rastelemente korrespondiert.

Eine weitere, besonders vorteilhafte Weiterbildung des Halters sieht vor, dass das Schwenklager eine Schwenklagerdrehachse aufweist, wobei die Schwenklagerdrehachse in einer Ebene des ersten und/oder des zweiten Drehlagerabschnitts angeordnet ist. Somit kann ein Halter bereitgestellt werden, bei dem das Drehlager und das Schwenklager besonders platzsparend und kompakt realisiert werden können, so dass ein Halter mit einer insgesamt geringeren Baugröße bereitgestellt werden kann, der somit besonders nah an einem Bauteil, bspw. besonders nah an den Kopfstützenstangen eines Kraftfahrzeugs montiert werden kann.

Die eingangs genannte Aufgabe wird ferner durch eine Befestigungseinrichtung mit den Merkmalen des Anspruchs 12 gelöst. Eine derartige Befestigungseinrichtung umfasset einen Halter nach wenigstens einem der Ansprüche 1 bis 11 und wenigstens eine Montagevorrichtung, welche eine Aufnahmebuchse aufweist, die zur lösbaren Befestigung des Befestigungselements des Halters ausgelegt ist.

Eine erste vorteilhafte Weiterbildung der Befestigungseinrichtung sieht vor, dass die Montagevorrichtung einen Grundteil mit einer Aufnahme aufweist, die zur Anordnung an einem rohrförmigen Bauteil ausgelegt ist, und dass die Montagevorrichtung ein bandförmiges Spannmittel aufweist, das zur spannenden Befestigung der Montagevorrichtung an dem rohrförmigen Bauteil durch Spannen des rohrförmigen Bauteils zwischen der Aufnahme und dem Spannmittel ausgelegt ist. Vorteilhafterweise ist dabei in der Aufnahme ein elastisch nachgiebiges Einlegeteil angeordnet, das bspw. aus Kautschuk oder einem Weichkunststoff hergestellt ist. Somit kann ein rohrförmiges Bauteil zur Befestigung der Montagevorrichtung an dem rohrförmigen Bauteil besonders einfach und zuverlässig zwischen der Aufnahme und dem bandförmigen Spannmittel eingespannt werden

Vorteilhafterweise umfasst das bandförmige Spannmittel einen Klettverschluss und/oder einen Kabelbinder und/oder einen Exzenterspanner.

Eine weitere vorteilhafte Ausgestaltung der Befestigungseinrichtung sieht vor, dass die Montagevorrichtung einen Saugnapf aufweist, der zur Befestigung an einer ebenen Oberfläche ausgelegt ist. Vorteilhafterweise umfasst die Montagevorrichtung dabei einen Lösehebel, der zum Lösen des Saugnapfs ausgelegt ist.

Eine weitere vorteilhafte Weiterbildung der Befestigungseinrichtung sieht vor, dass die Montagevorrichtung zur Befestigung an einer Wand ausgelegt ist. Dabei ist es denkbar, dass die Montagevorrichtung einen nutensteinförmigen Befestigungsabschnitt aufweist, der Bohrungen aufweist, mittels derer der Befestigungsabschnitt bzw. die Montagevorrichtung an einer Wand befestigt werden kann.

Gemäß einer weiteren, besonders vorteilhafte Ausgestaltung der Befestigungseinrichtung ist es denkbar, dass ein Verlängerungsteil vorgesehen ist, das ein Befestigungselement und eine, insbesondere axial zum Befestigungselement angeordnete, Aufnahmebuchse aufweist, die in axialer Richtung vom Befestigungselement beabstandet angeordnet ist. Somit kann das Befestigungselement des Halters in die Aufnahmebuchse des Verlängerungsteils eingesteckt werden, wobei das Befestigungselement des Verlängerungsteils in die Aufnahmebuchse der Montagevorrichtung eingesteckt werden kann. Dies ermöglicht eine Verlängerung des Abstands zwischen Schwenklager 32 und Aufnahmebuchse der Montagevorrichtung, so dass die Befestigungseinrichtung insgesamt besser an die jeweilige Montageanforderung angepasst werden kann.

Weitere Einzelheiten und vorteilhafte Weiterbildungen der Erfindung sind der nachfolgenden Beschreibung zu entnehmen anhand derer verschiedene Ausführungsformen der Erfindung näher beschrieben und erläutert ist.

Es zeigen:
- Figur 1: eine perspektivische Vorderansicht einer ersten Ausführungsform eines erfindungsgemäßen Halters;
- Figur 2: eine perspektivische Rückansicht des Halters gemäß Figur 2;
- Figur 3: einen Ausschnitt eines Schnitts durch den Halter gemäß der Figuren 1 und 2;
- Figur 4: eine teilweise Explosionsdarstellung von Bauteilen des Halters gemäß der Figuren 1 und 2
- Figur 5: eine perspektivische Rückansicht einer zweiten Ausführungsform eines erfindungsgemäßen Halters;
- Figur 6: einen Ausschnitt einer ersten Ausführungsform einer erfindungsgemäßen Befestigungseinrichtung;
- Figur 7: einen Ausschnitt einer zweiten Ausführungsform einer erfindungsgemäßen Befestigungseinrichtung;
- Figur 8: einen Ausschnitt einer dritten Ausführungsform einer erfindungsgemäßen Befestigungseinrichtung;
- Figur 9: einen Ausschnitt einer vierten Ausführungsform einer erfindungsgemäßen Befestigungseinrichtung; und
- Figur 10: einen Ausschnitt einer fünften Ausführungsform einer erfindungsgemäßen Befestigungseinrichtung.

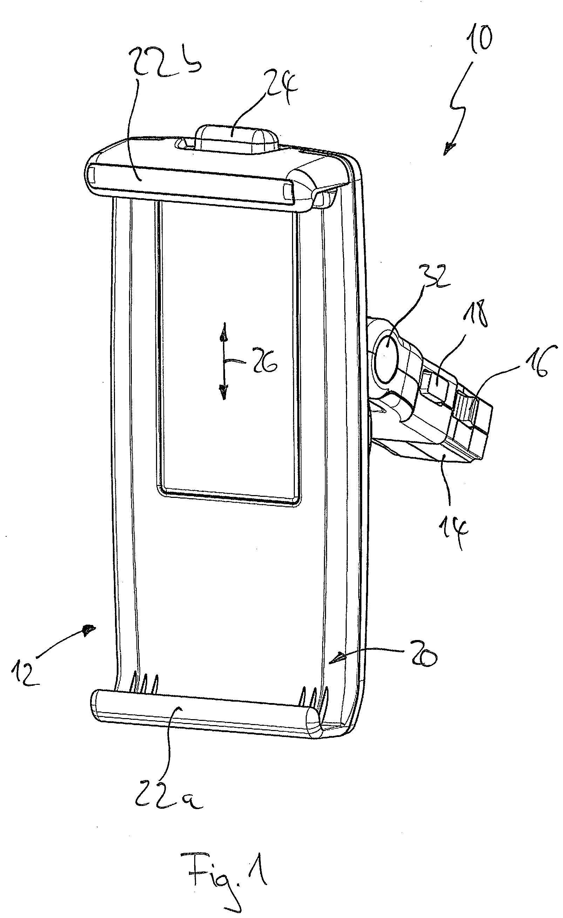

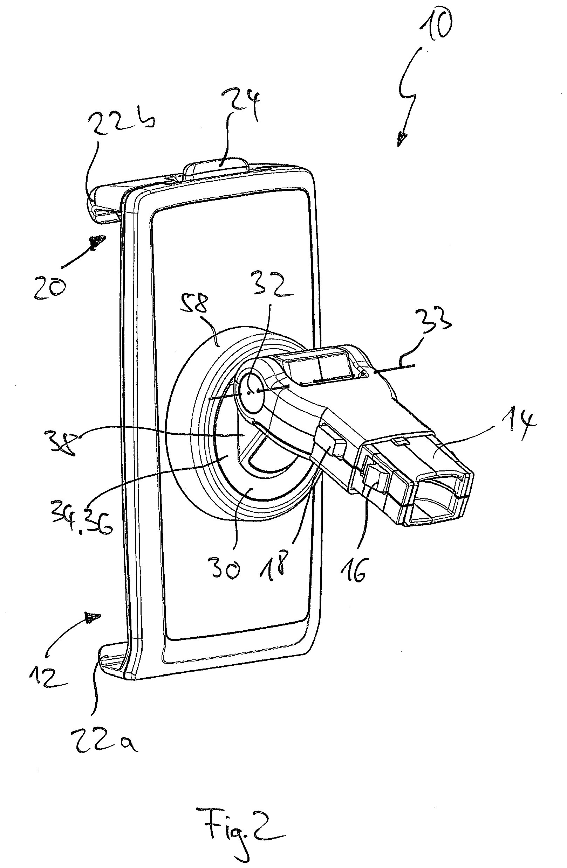

In den Figuren 1 bis 4 ist insgesamt eine erste Ausführungsform eines erfindungsgemäßen Halters 10 zur lösbaren Befestigung eines in den Figuren nicht gezeigten flachen, in etwa rechteckigen Geräts wie eines Tablet-Computers oder eines Smartphones an einem Bauteil, insbesondere an einem Bauteil eines Kraftfahrzeugs gezeigt. Figur 1 zeigt den Halter 10 in einer perspektivischen Vorderansicht, wobei der Halter 10 in Figur 2 in einer perspektivischen Rückansicht gezeigt ist.

Der Halter 10 umfasst eine Halteeinrichtung 12 zur lösbaren Halterung des Geräts und ein Befestigungselement 14 zur Verbindung des Halters 10 mit dem Bauteil, bspw. mit einer dafür vorgesehenen Buchse in einem Kraftfahrzeug oder mit einer aus der EP 2 437 960 B1 bekannten Befestigungseinrichtung zum Anschließen an zwei voneinander beabstandete Kopfstützenstangen eines Fahrzeugsitzes.

Zum Verankern des Befestigungselements 14 weist der Halter 10 Rastnasen 16 auf, die mittels der Druckknöpfe 18 entriegelt werden können. Die Halteeinrichtung 12 weist eine Aufnahme 20 für das Gerät und im Bereich der Aufnahme 20 angeordnete, klammerartige Halteelemente 22a, 22b zur Halterung des Geräts auf. Wie in den Figuren 1 und 2 deutlich zu erkennen ist, weist die Halteeinrichtung 12 in einem oberen Bereich ferner einen Druckknopf 24 auf, mittels derer eine Verlagerung der Halteelemente 22a, 22b gegenüber einander in Richtung des Doppelpfeils 26 und entsprechend eine Größenanpassung der Halteeinrichtung 12 ermöglicht ist. Die Halteeinrichtung 12 ist jedoch Gegenstand einer anderen Patentanmeldung und wird an dieser Stelle nicht näher erläutert.

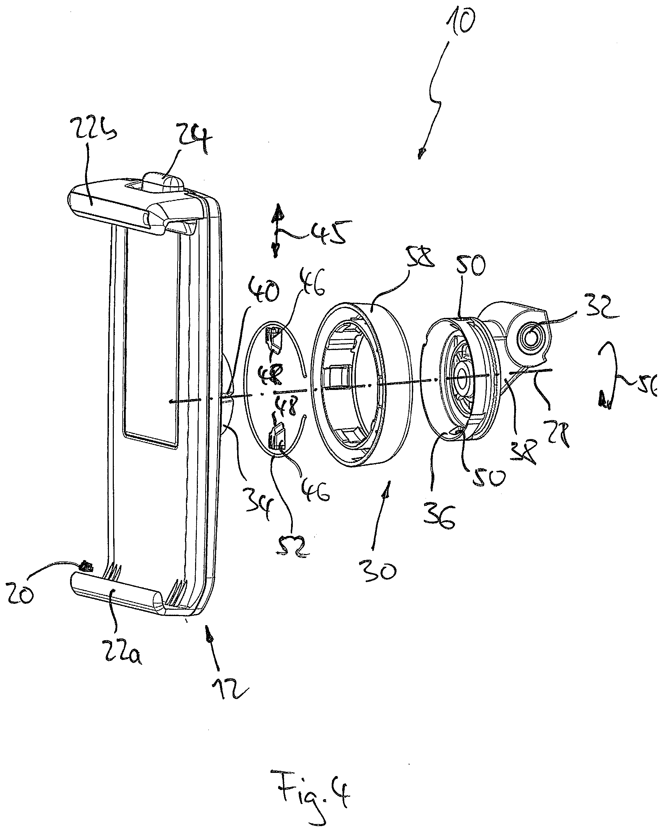

Der Halter 10 weist ein um eine Drehachse 28 (siehe Figur 4) drehbares Drehlager 30 auf, das mit der Halteeinrichtung 12 verbunden ist. Der Halter 10 weist ferner ein mit dem Drehlager 30 verbundenes Schwenklager 32 auf, das mit dem Befestigungselement 14 verbunden ist.

Das Drehlager 30 weist eines ersten, mit der Halteeinrichtung 12 fest verbundenen Drehlagerabschnitt 34 auf, der auf der der Aufnahme 20 abgewandten Seite der Halteeinrichtung 12 angeordnet ist. Das Drehlager 30 weist ferner einen zweiten, mit dem Befestigungselement 14 verbundenen Drehlagerabschnitt 36 auf. Der Halter 10 weist ein Verbindungselement 38 auf, wobei der zweite Drehlagerabschnitt 36 am Verbindungselement 38 angeordnet ist und wobei das Verbindungselement 38 Schwenklagerabschnitte des Schwenklagers 32 aufweist. Das Schwenklager 32 dreht dabei um eine Schwenklagerdrehachse 33, die senkrecht zur Drehachse 28 des Drehlagers 30 angeordnet ist.

Der erste Drehlagerabschnitt 34 ist als Konus ausgebildet und der zweite Drehlagerabschnitt 36 ist als Gegenkonus ausgebildet. Die beiden Konusse der Drehlagerabschnitte 34, 36 sind koaxial zur Drehachse 28 angeordnet. Am ersten Drehlagerabschnitt 34 sind vier Rastnuten 40 vorgesehen, die über den Umfang des ersten Drehlagerabschnitts 34 in einem Winkel von jeweils 90° zueinander angeordnet sind. Die Rastnuten 40 sind als V-Nuten ausgebildet.

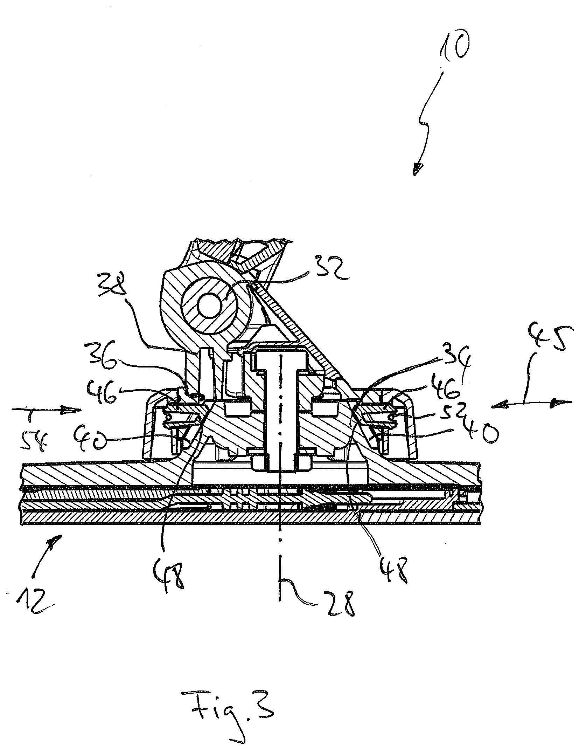

Wie insbesondere im Schnitt gemäß Figur 3 zu erkennen ist, sind die beiden Drehlagerabschnitte 34, 36 mittels einer Schraube 42 und einer Mutter 44 miteinander verbunden. Die Schraube 42 und die Mutter 44 sind koaxial zur Drehachse 28 des Drehlagers 30 angeordnet und in der Explosionsdarstellung der Figur 4 zur besseren Übersichtlichkeit nicht gezeigt.

Um eine Verrastung des Drehlagers 30 bzw. des ersten Drehlagerabschnitts 34 gegenüber dem zweiten Drehlagerabschnitt 36 zu ermöglichen, sind am Drehlager 30 senkrecht zur Drehachse 28 zwei zwischen einer radial inneren Rastposition und einer radial äußeren Freigabeposition in Richtung des Doppelpfeils 45 verlagerbare Rastelemente 46 vorgesehen. Die Rastelemente 46 sind spiegelbildlich zur Drehachse 28 angeordnet.

In der Freigabeposition der Rastelemente 46 sind die beiden Drehlagerabschnitte 34, 36 gegenüber einander verdrehbar, wobei die Drehlagerabschnitte 34, 36 gegenüber einander fixiert sind, wenn die Rastelemente 46 in der Rastposition sind.

Zur Verrastung der beiden Drehlagerabschnitte 34, 36 weisen die Rastelemente 46 in Figur 3 deutlich erkennbare Rastabschnitte 48 auf, die mit den Rastnuten 44 derart korrespondieren, dass die Rastabschnitte 48 in der Rastposition zumindest teilweise in die Rastnuten 40 eingerückt sind.

Die Rastabschnitte 48 weisen ebenfalls ein V-förmiges Profil aus, das mit dem V-Nuten-Profil der Rastnuten 40 korrespondiert.

Am zweiten Drehlagerabschnitt 36 sind zwei ebenfalls spiegelbildlich zur Drehachse 28 angeordnete Führungsabschnitte 50 zur Führung der Rastelemente 46 vorgesehen, wobei diese Führungsabschnitte 50 zur Führung der Rastelemente 46 ausgelegt sind. Daher weisen die Führungsabschnitte 50 senkrecht zur Drehachse 28 ein Innenprofil auf, das mit dem Außenprofil der Rastelemente 46 in Richtung des Pfeils 45 korrespondiert. Vorzugsweise ist daher ein Innenprofil der Führungsabschnitte 50 nur minimal größer als ein Außenprofil der Rastelemente 46.

Radial außerhalb der Rastelemente 46 ist eine Ringfeder 52 aus einem Federstahl vorgesehen, die derart ausgebildet und angeordnet ist, dass die Rastelemente 46 mittels der Ringfeder 52 nach radial innen, d.h. in Richtung des Pfeils 54 in die Rastposition vorgespannt sind.

Die Führungsabschnitte 50 sind mit dem zweiten Drehlagerabschnitt 36 drehfest verbunden bzw. sind in den zweiten Drehlagerabschnitt 36 bspw. mittels eines Kunststoffspritzgussverfahrens eingegossen, wobei die Rastelemente 46 in den Führungsabschnitten 50 geführt sind. Aufgrund der drehfest mit dem zweiten Drehlagerabschnitt 36 verbundenen Führungsabschnitte 50 können die in den Führungsabschnitten 50 geführten Rastelemente 46 zur Verrastung mit dem ersten Drehlagerabschnitt 34 in die Rastnuten 40 derart einrücken, dass der erste Drehlagerabschnitt 34 gegenüber dem zweiten Drehlagerabschnitt 36 fixiert ist.

Da die Rastnuten 40 und die Rastabschnitte 48 ein V-förmiges Profil mit Schrägflächen aufweisen, führt ein Verdrehen des ersten Drehlagerabschnitts 34 gegenüber dem zweiten Drehlagerabschnitt 36 in Richtung des Pfeils 56 durch ein Abgleiten der Schrägflächen der Rastnuten 40 und der Schrägflächen der Rastabschnitte 48 der Rastelemente 46 aufeinander zu einer Verlagerung der Rastelemente 46 in die Freigabeposition entgegen der Federkraft der Ringfeder 52.

Das Drehlager 30 ist insgesamt mit einer Abdeckung 58 vor Verschmutzungen geschützt.

Mit einem erfindungsgemäßen Halter 10 kann aufgrund der direkten Anbindung des Drehlagers 30 an die Halteeinrichtung 12 einerseits eine besonders stabile Befestigungsmöglichkeit auch für Tablet-Computer mit einer Größe von mehr als 13 Zoll bereitgestellt werden. Andererseits ist aufgrund der Rastelemente 46, welche durch die Ringfeder 52 in die Rastposition beaufschlagt werden, und aufgrund der vier Rastnuten 40 eine einfache und sichere Möglichkeit der Verrastung des Halters 10 in einer Hochformatstellung und einer Querformatstellung realisiert.

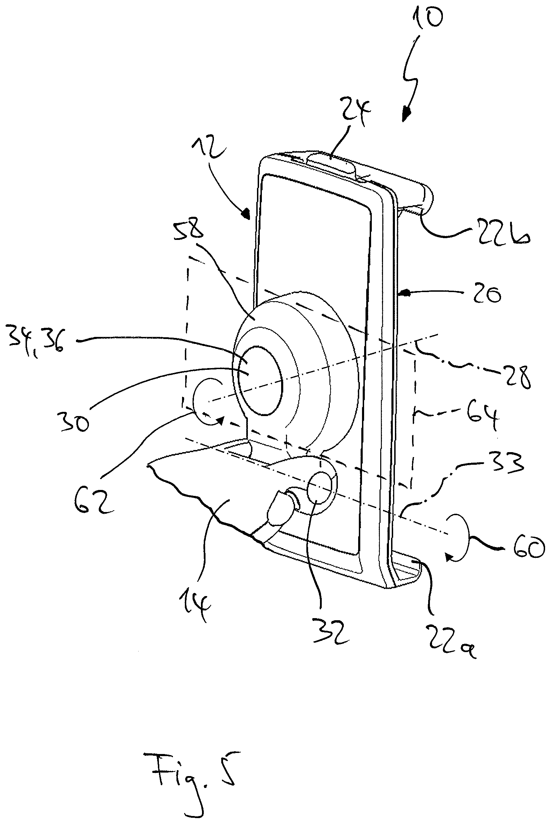

Figur 5 zeigt eine zweite Ausführungsform des erfindungsgemäßen Halters 10. Sich entsprechend Bauteile und Elemente sind dabei mit den sich entsprechenden Bezugszeichen gekennzeichnet. Bei dem in Figur 5 gezeigten Halter 10 lässt sich der Halter 10 um die Schwenklagerdrehachse 33 des Schwenklagers 32 in Richtung des Pfeils 60 verschwenken. Ferner lässt sich der Halter 10, wie oben dargelegt, um die Drehachse 28 des Drehlagers 30 in Richtung des Pfeils 62 um 360° drehen. Die Schwenklagerdrehachse 33 ist dabei in einer Ebene 64 des ersten und/oder des zweiten Drehlagerabschnitts 34, 36 angeordnet. Somit kann ein Halter 10 bereitgestellt werden, bei dem das Drehlager 30 und das Schwenklager 32 besonders platzsparend und kompakt realisiert werden können, so dass ein Halter 10 mit einer insgesamt geringeren Baugröße bereitgestellt werden kann, der somit besonders nah an einem Bauteil, bspw. besonders nah an den Kopfstützenstangen eines Kraftfahrzeugs montiert werden kann.

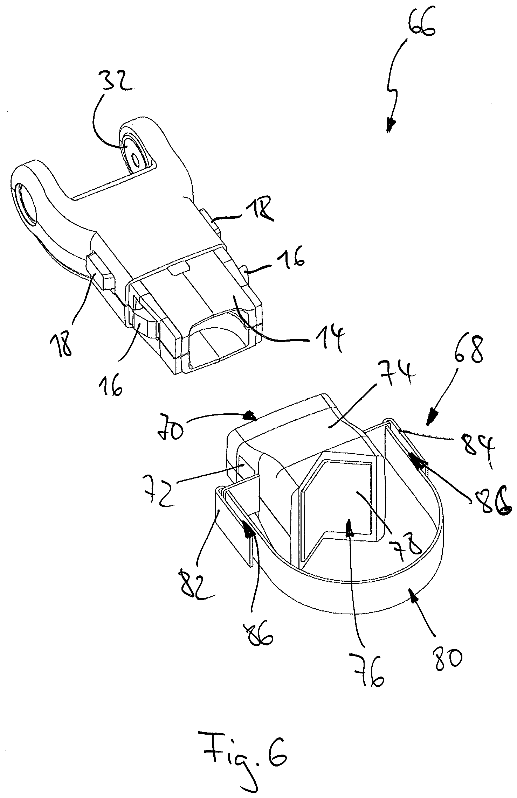

Die Figuren 6 bis 10 zeigen eine erste bis fünfte Ausführungsform eines Ausschnitts einer erfindungsgemäßen Befestigungseinrichtung 66, die einen erfindungsgemäßen Halter 10 und eine Montagevorrichtung 68 umfasst. Sich entsprechend Bauteile und Elemente sind dabei mit den sich entsprechenden Bezugszeichen gekennzeichnet. Die Montagevorrichtung 68 weist jeweils eine Aufnahmebuchse 70 auf, die zur lösbaren Befestigung des Befestigungselements 14 des Halters 10 ausgelegt ist. Wenn der Halter 10 an der Montagevorrichtung 68 angeordnet ist, ist das Befestigungselement 14 vollständig in die Aufnahmebuchse 70 eingerückt und die Rastnasen 16 sind in Rastöffnungen 72 der jeweiligen Montagevorrichtung 68 verrastet.

Die Montagevorrichtungen 68 unterscheiden sich jeweils nur in der Art und Weise ihrer Befestigung.

Die Montagevorrichtungen 68 der in den Figuren 6 bis 8 gezeigten Befestigungseinrichtungen 66 weisen einen Grundteil 74 mit einer Aufnahme 76 auf, die zur Anordnung an einem in den Figuren nicht gezeigten stab- oder rohrförmigen Bauteil ausgelegt ist. In der Aufnahme 76 ist ein elastisch nachgiebiges Einlegeteil 78 angeordnet, das bspw. aus Kautschuk oder einem Weichkunststoff hergestellt ist.

Die Montagevorrichtungen 68 weisen jeweils ein bandförmiges Spannmittel 80 auf, das zur spannenden Befestigung der Montagevorrichtungen 68 an dem rohrförmigen Bauteil durch Spannen des rohrförmigen Bauteils zwischen der Aufnahme 76 und dem Spannmittel 80 ausgelegt ist. Aufgrund des elastisch nachgiebigen Einlegeteils 78 kann ein rohrförmiges Bauteil zur Befestigung der Montagevorrichtung 68 an dem rohrförmigen Bauteil besonders einfach und zuverlässig zwischen der Aufnahme 76 und dem bandförmigen Spannmittel 80 eingespannt werden.

Das bandförmigem Spannmittel 80 weist dabei jeweils ein erstes und ein zweites Ende 82, 84 auf, mittels dem es jeweils am Grundteil 74 der Montagevorrichtungen 68 an einer jeweiligen, der Aufnahme 76 benachbarten Seite befestigbar ist.

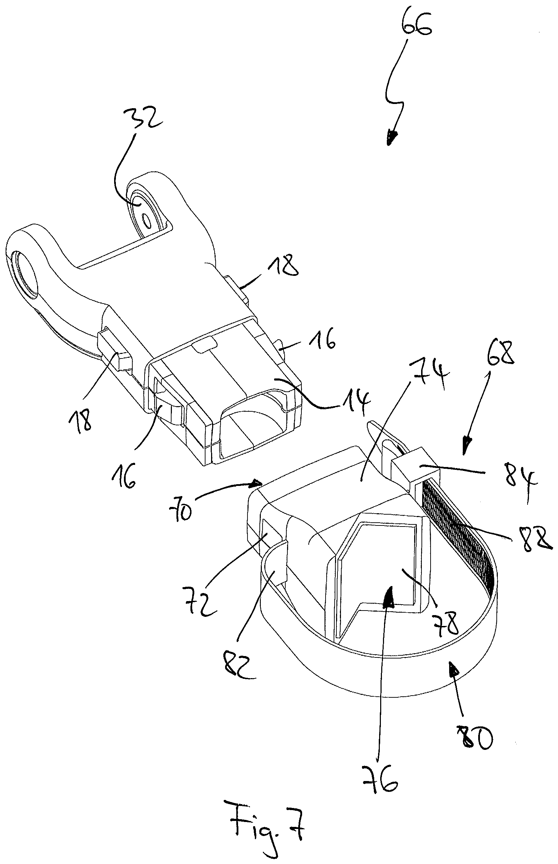

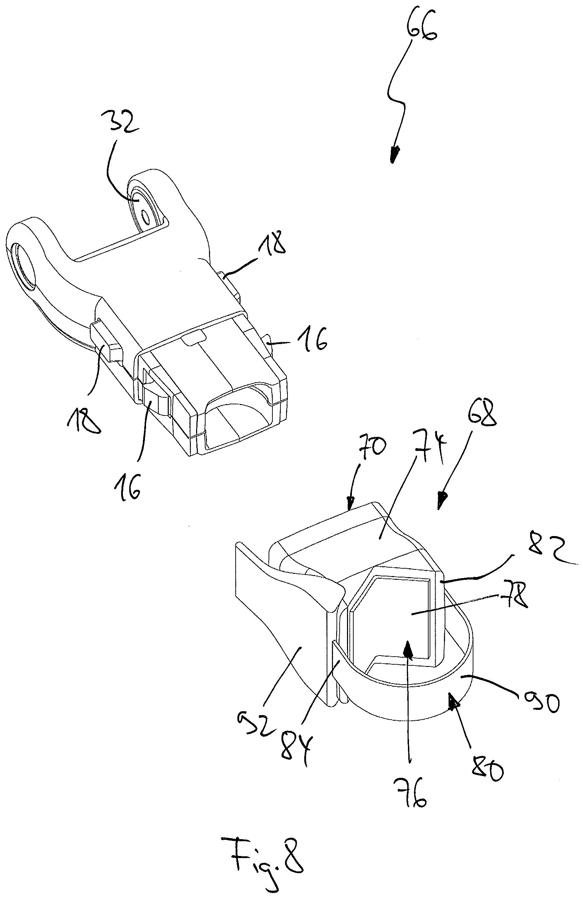

Bei der Ausführungsform der Figur 6 umfasst das bandförmige Spannmittel einen Klettverschluss 86. Bei der Ausführungsform der Figur 7 umfasst das bandförmige Spannmittel einen Kabelbinder 88. Bei der Ausführungsform der Figur 8 umfasst das bandförmige Spannmittel einen Exzenterspanner 90 mit einem Kniehebel 92.

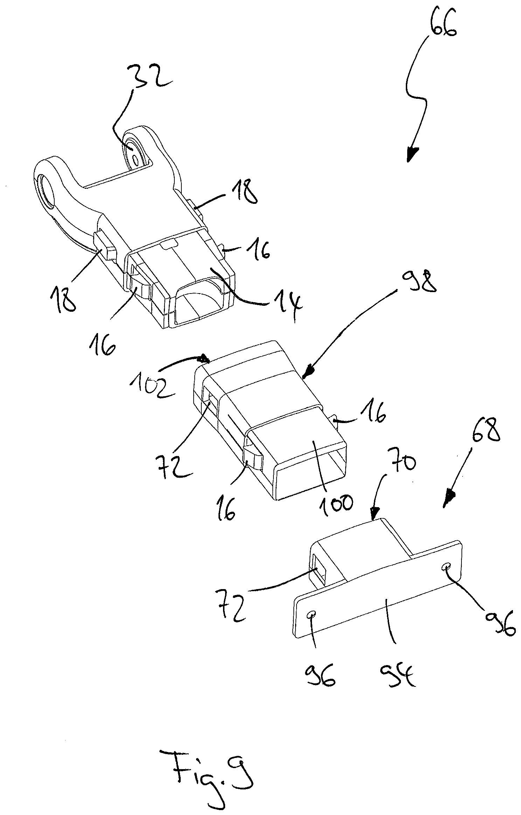

Die in Figur 9 gezeigte Befestigungseinrichtung 66 umfasst eine Montagevorrichtung 68, die zur Befestigung an einer Wand ausgelegt ist. Diese Montagevorrichtung umfasst einen nutensteinförmigen Befestigungsabschnitt 94, der Bohrungen 96 aufweist, mittels derer der Befestigungsabschnitt 94 bzw. die Montagevorrichtung 68 an einer Wand befestigt werden kann. Darüber hinaus umfasst die in Figur 9 gezeigte Befestigungseinrichtung 66 ein Verlängerungsteil 98, das ein zum Befestigungselement 14 identisches Befestigungselement 100 und eine, insbesondere axial zum Befestigungselement 100 angeordnete, Aufnahmebuchse 102 aufweist, die in axialer Richtung vom Befestigungselement 100 beabstandet angeordnet ist und identisch mit der Aufnahmebuchse 70 der Montagevorrichtungen 68 ausgebildet ist. Das Verlängerungsteil weist ferner Rastnasen 16 und Rastöffnungen 72 auf. Somit kann das Befestigungselement 14 des Halters 10 in die Aufnahmebuchse 102 des Verlängerungsteils 98 eingesteckt werden, wobei das Befestigungselement 100 des Verlängerungsteils 98 in die Aufnahmebuchse 70 der Montagevorrichtung 68 eingesteckt werden kann. Dies ermöglicht eine Verlängerung des Abstands zwischen Schwenklager 32 und der Aufnahmebuchse 70 der Montagevorrichtung 68, so dass die Befestigungseinrichtung 66 insgesamt besser an die jeweilige Montageanforderung angepasst werden kann.

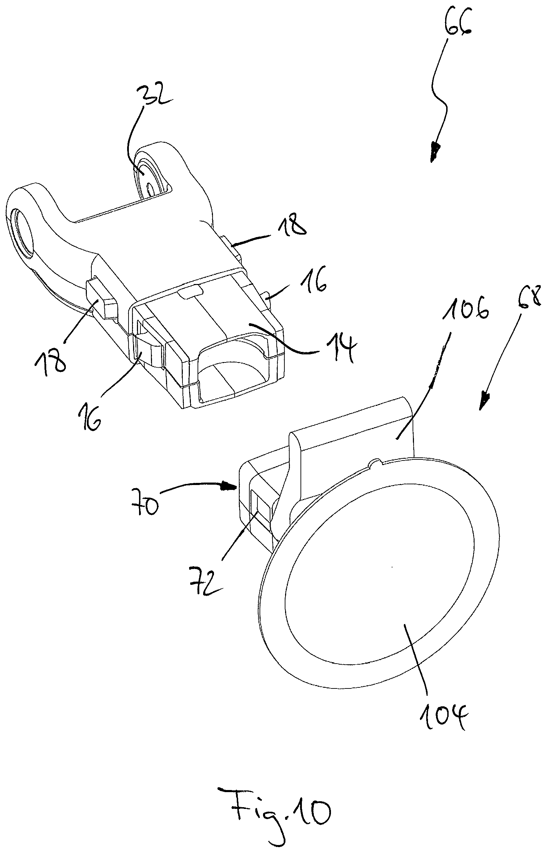

Bei der in Figur 10 gezeigten Ausführungsform der Befestigungseinrichtung 66 weist die Montagevorrichtung 68 einen Saugnapf 104 auf, der zur Befestigung an einer ebenen Oberfläche ausgelegt ist. Ferner weist die Montagevorrichtung 68 dabei einen Lösehebel 106 auf, der zum Lösen des Saugnapfs 104 ausgelegt ist.

## Patentansprüche

1. Halter (10) zur lösbaren Befestigung eines flachen, in etwa rechteckigen Geräts wie eines Tablet-Computers oder eines Smartphones an einem Bauteil, insbesondere an einem Bauteil eines Kraftfahrzeugs, wobei der Halter (10) eine Halteeinrichtung (12) zur lösbaren Halterung des Geräts und ein mit der Haltereinrichtung (12) verbundenes Befestigungselement (14) zur Verbindung des Halters (10) mit dem Bauteil aufweist, wobei ein um eine Drehachse (28) drehbares Drehlager (30) vorgesehen ist, das mit der Haltereinrichtung (12) verbunden ist und wobei ein mit dem Drehlager (30) verbundenes Schwenklager (32) vorgesehen sind, das mit dem Befestigungselement (14) verbunden ist, wobei das Drehlager (30) einen ersten mit der Halteeinrichtung (12) verbundenen Drehlagerabschnitt (34) und einen zweiten mit dem Befestigungselement (14) verbundenen Drehlagerabschnitt (36) aufweist, wobei am Drehlager (30) senkrecht zur Drehachse (28) des Drehlagers (30) zwischen einer radial inneren Rastposition und einer radial äußeren Freigabeposition verlagerbare Rastelemente (46) vorgesehen sind, wobei der erste Drehlagerabschnitt (34) gegenüber dem zweiten Drehlagerabschnitt (36) in der Freigabeposition verdrehbar ist und wobei der erste Drehlagerabschnitt (34) gegenüber dem zweiten Drehlagerabschnitt (36) in der Rastposition fixiert ist, **dadurch gekennzeichnet, dass** eine Ringfeder (52) vorgesehen ist, die derart ausgebildet und angeordnet ist, dass die Rastelemente (46) mittels der Ringfeder (52) nach radial innen in die Rastposition vorgespannt sind.

2. Halter (10) nach Anspruch 1, **dadurch gekennzeichnet, dass** die Halteeinrichtung (12) eine Aufnahme (20) für das Gerät und im Bereich der Aufnahme (20) angeordnete Halteelemente (22a, 22b) zur Halterung des Geräts aufweist und dass der erste Drehlagerabschnitt (34) auf der der Aufnahme (20) abgewandten Seite der Halteeinrichtung (12) angeordnet ist.

3. Halter (10) nach Anspruch 1 oder 2, **dadurch gekennzeichnet, dass** ein Verbindungselement (38) vorgesehen ist, wobei der zweite Drehlagerabschnitt (36) am Verbindungselement angeordnet ist und wobei das Verbindungselement (36) Schwenklagerabschnitte des Schwenklagers (32) aufweist.

4. Halter (10) nach wenigstens einem der vorherigen Ansprüche, **dadurch gekennzeichnet, dass** der erste Drehlagerabschnitt (34) als Konus ausgebildet ist, wobei der zweite Drehlagerabschnitt (36) als Gegenkonus ausgebildet ist.

5. Halter (10) nach wenigstens einem der vorherigen Ansprüche, **dadurch gekennzeichnet, dass** am ersten Drehlagerabschnitt (34) mehrere, vorzugsweise 4 Rastnuten (40) vorgesehen sind, die über den Umfang des ersten Drehlagerabschnitts (34) in regelmäßigen Abständen zueinander angeordnet sind.

6. Halter (10) nach Anspruch 5, **dadurch gekennzeichnet, dass** die Rastelemente (46) Rastabschnitte (48) aufweisen, die mit den Rastnuten (40) derart korrespondieren, dass die Rastabschnitte (48) in der Rastposition zumindest teilweise in die Rastnuten eingerückt sind.

7. Halter (10) nach Anspruch 6, **dadurch gekennzeichnet, dass** die Rastnuten (40) und die Rastabschnitte (48) ein Profil aufweisen, das derart ausgebildet ist, dass ein Verdrehen des ersten Drehlagerabschnitts (34) gegenüber dem zweiten Drehlagerabschnitt (36) zu einer Verlagerung der Rastelemente (48) von der Rastposition in die Freigabeposition entgegen der Federkraft der Ringfeder (52) führt.

8. Halter (10) nach wenigstens einem der vorherigen Ansprüche, **dadurch gekennzeichnet, dass** mehrere, vorzugsweise 2 Rastelemente (46) vorgesehen sind, die spiegelbildlich zur Drehachse (28) angeordnet sind.

9. Halter (10) nach wenigstens einem der vorherigen Ansprüche, **dadurch gekennzeichnet, dass** am zweiten Drehlagerabschnitt (36) mehrere, vorzugsweise 2 Führungsabschnitte (50) für die Rastelemente (46) vorgesehen sind, die spiegelbildlich zur Drehachse (28) angeordnet sind.

10. Halter (10) nach wenigstens einem der vorherigen Ansprüche, **dadurch gekennzeichnet, dass** die Führungsabschnitte (50) zur Führung der Rastelemente (46) ausgelegt sind.

11. Halter (10) nach wenigstens einem der vorherigen Ansprüche, **dadurch gekennzeichnet, dass** das Schwenklager (32) eine Schwenklagerdrehachse (33) aufweist, wobei die Schwenklagerdrehachse (33) in einer Ebene (64) des ersten und/oder des zweiten Drehlagerabschnitts (64, 66) angeordnet ist.

12. Befestigungseinrichtung (66) umfassend einen Halter (10) nach wenigstens einem der Ansprüche 1 bis 11 und wenigstens eine Montagevorrichtung (68), welche eine Aufnahmebuchse (70) aufweist, die zur lösbaren Befestigung des Befestigungselements (14) des Halters (10) ausgelegt ist.

13. Befestigungseinrichtung (66) nach Anspruch 12, **dadurch gekennzeichnet, dass** die Montagevorrichtung (68) einen Grundteil (74) mit einer Aufnahme (76) aufweist, die zur Anordnung an einem rohrförmigen Bauteil ausgelegt ist, und dass die Montagevorrichtung (68) ein bandförmiges Spannmittel (80) aufweist, das zur spannenden Befestigung der Montagevorrichtung (68) an dem rohrförmigen Bauteil durch Spannen des rohrförmigen Bauteils zwischen der Aufnahme (76) und dem Spannmittel (80) ausgelegt ist.

14. Befestigungseinrichtung (66) nach Anspruch 13, **dadurch gekennzeichnet, dass** das bandförmige Spannmittel (80) einen Klettverschluss (86) und/oder einen Kabelbinder (88) und/oder einen Exzenterspanner (90) umfasst.

15. Befestigungseinrichtung (66) nach Anspruch 12, **dadurch gekennzeichnet, dass** die Montagevorrichtung (68) einen Saugnapf (104) aufweist, der zur Befestigung an einer ebenen Oberfläche ausgelegt ist.

16. Befestigungseinrichtung (66) nach Anspruch 12, **dadurch gekennzeichnet, dass** die Montagevorrichtung (68) zur Befestigung an einer Wand ausgelegt ist.

17. Befestigungseinrichtung (66) nach wenigstens einem der Ansprüche 12 bis 15, **dadurch gekennzeichnet, dass** ein Verlängerungsteil (98) vorgesehen ist, das ein Befestigungselement (100) und eine, insbesondere axial zum Befestigungselement (100) angeordnete, Aufnahmebuchse (102) aufweist, die in axialer Richtung vom Befestigungselement (100) beabstandet angeordnet ist.

## Claims

1. Holder (10) for detachably fastening of a flat, approximately rectangular device like a tablet computer or a smartphone to a component, in particular a component of a motor vehicle, wherein the holder (10) comprises a holding mechanism (12) for detachably holding the device and a fastening element (14) that is connected to the holding mechanism (12) to connect the holder (10) with the component, wherein a rotary bearing (30) is provided that is rotatable around an axis of rotation (28), wherein the rotary bearing (30) is connected to the holding mechanism (12), and wherein a pivot bearing (32) is provided which is connected to the rotary bearing (30) and which is connected to the fastening element (14), wherein the rotary bearing (30) comprises a first rotary bearing portion (34) connected to the holding mechanism (12) and a second rotary bearing portion (36) connected to the fastening element (14), wherein locking elements (46) are provided on the rotary bearing (30) perpendicular to the axis of rotation (28) of the rotary bearing (30), the locking elements being displaceable between a radial inner locking position and a radial outer release position, wherein in the release position the first rotary bearing portion (34) is rotatable in relation to the second rotary bearing portion (36) and wherein in the locking position the first rotary bearing portion (34) is fixed in relation to the second rotary bearing portion (36), **characterized in that** an annular spring (52) is provided which is designed and arranged such that the locking elements (46) are pre-stressed in a radially inward direction into the locking position by the annular spring (52).

2. Holder (10) according to claim 1, **characterized in that** the holding mechanism (12) comprises a receiving portion (20) for the device and holder elements (22a, 22b) located in the region of the receiving portion for holding the device, and **in that** the first rotary bearing portion (34) is located on the side of the holding mechanism (12) facing away from the receiving portion (20) .

3. Holder (10) according to claim 1 or 2, **characterized in that** a connecting element (38) is provided, wherein the second rotary bearing portion (36) is located on the connecting element and wherein the connecting element (38) comprises pivot bearing portions of the pivot bearing (32).

4. Holder (10) according to at least one of the preceding claims, **characterized in that** the first rotary bearing portion (34) is designed as a cone, wherein the second rotary bearing portion (36) is designed as a counter-cone.

5. Holder (10) according to at least one of the preceding claims, **characterized in that** at the first rotary bearing portion (34) multiple, preferably 4, locking grooves (40) are provided which are arranged at regular distances from one another with respect to the circumference of the first rotary bearing portion (34).

6. Holder (10) according to claim 5, **characterized in that** the locking elements (46) comprise locking portions (48) that correspond with the locking grooves (40) such that the locking portions (48) at least partially engage into the locking grooves when in locking position.

7. Holder (10) according to claim 6, **characterized in that** the locking grooves (40) and the locking portions (48) comprise a profile designed in such a way that rotation of the first rotary bearing portion (34) in relation to the second rotary bearing portion (36) results in a displacement of the locking elements (48) from the locking position to the release position against the spring force of the annular spring (52).

8. Holder (10) according to at least one of the preceding claims, **characterized in that** multiple, preferably 2 locking elements (46) are provided in a mirror symmetrical manner with respect to the axis of rotation (28) .

9. Holder (10) according to at least one of the preceding claims, **characterized in that** multiple, preferably 2 guide portions (50) are provided on the second rotary bearing (36) for the locking elements (46) which are arranged in a mirror symmetrical manner with respect to the axis of rotation (28).

10. Holder (10) according to at least one of the preceding claims, **characterized in that** the guide portions (50) are designed to guide the locking elements (46).

11. Holder (10) according to at least one of the preceding claims, **characterized in that** the pivot bearing (32) comprises a pivot bearing axis of rotation (33), wherein the pivot bearing axis of rotation (33) is located in a plane (64) of the first and/or second rotary bearing portion (34, 36).

12. Fastening fixture (66) including a holder (10) according to at least one of the claims 1 to 11 and at least one mounting fixture (68) that comprises a receiving socket (70), which is designed for detachably fastening of the fastening element (14) of the holder (10).

13. Fastening fixture (66) according to claim 12, **characterized in that** the mounting fixture (68) comprises a base part (74) with a receiving portion (76) designed for being arranged at a tube-shaped component, and **in that** the mounting fixture (68) comprises a band-shaped tensioning device (80) designed for tensioning of the mounting fixture (68) at the tube-shaped component by tensioning the tube-shaped component between the receiving portion (76) and the tensioning device (80).

14. Fastening fixture (66) according to claim 13, **characterized in that** the band-shaped tensioning device (80) includes a hook-and-loop fastener (86) and/or a cable tie (88) and/or an eccentric tensioning device (90) .

15. Fastening fixture (66) according to claim 12, **characterized in that** the mounting fixture (68) comprises a suction cup (104) designed for being fastened onto an even surface.

16. Fastening fixture (66) according to claim 12, **characterized in that** the mounting fixture (68) is designed for being fastened onto a wall.

17. Fastening fixture (66) according to at least one of the claims 12 to 15, **characterized in that** an extension piece (98) is provided that comprises a fastening element (100) and a receiving socket (102), the receiving socket (102) being arranged away from the fastening element (100) with respect to an axial direction, wherein the receiving socket (102) is preferably arranged axially with respect to the fastening element (100).

## Revendications

1. Support (10) permettant de fixer de manière amovible un appareil plat approximativement rectangulaire, tel qu'une tablette ou un smartphone, à un composant, en particulier à un composant d'un véhicule automobile, dans lequel le support (10) présente un dispositif de retenue (12) permettant de retenir l'appareil de manière amovible, et un élément de fixation (14) relié au dispositif de retenue (12) afin de relier le support (10) au composant, dans lequel un palier de rotation (30) pouvant tourner autour d'un axe de rotation (28) et relié au dispositif de retenue (12) est prévu et dans lequel un palier de basculement (32) relié au palier de rotation (30) et relié à l'élément de fixation (14) est prévu, dans lequel le palier de rotation (30) présente une première partie de palier de rotation (34) reliée au dispositif de retenue (12) et une seconde partie de palier de rotation (36) reliée à l'élément de fixation (14), dans lequel des éléments de verrouillage (46) pouvant être déplacés de manière perpendiculaire à l'axe de rotation (28) du palier de rotation (30) entre une position de verrouillage radialement intérieure et une position de libération radialement extérieure sont prévus au niveau du palier de rotation (30), dans lequel la première partie de palier de rotation (34) peut être tournée dans la position de libération par rapport à la seconde partie de palier de rotation (36) et dans lequel la première partie de palier de rotation (34) peut être immobilisée dans la position de verrouillage par rapport à la seconde partie de palier de rotation (36), **caractérisé en ce qu'**un ressort annulaire (52), réalisé et agencé de telle manière que les éléments de verrouillage (46) sont contraints radialement vers l'intérieur dans la position de verrouillage au moyen du ressort annulaire (52), est prévu.

2. Support (10) selon la revendication 1, **caractérisé en ce que** le dispositif de retenue (12) présente un réceptacle (20) pour l'appareil et des éléments de retenue (22a, 22b) permettant de retenir l'appareil et agencés dans la région du réceptacle (20) et **en ce que** la première partie de palier de rotation (34) est agencée du côté du dispositif de retenue (12) qui est détourné du réceptacle (20) .

3. Support (10) selon la revendication 1 ou 2, **caractérisé en ce qu'**un élément de liaison (38) est prévu, dans lequel la seconde partie de palier de rotation (36) est agencée au niveau de l'élément de liaison et dans lequel l'élément de liaison (36) présente des parties de palier de basculement du palier de basculement (32).

4. Support (10) selon l'une quelconque des revendications précédentes, **caractérisé en ce que** la première partie de palier de rotation (34) est réalisée sous forme de cône, dans lequel la seconde partie de palier de rotation (36) est réalisée sous forme de contre-cône.

5. Support (10) selon l'une quelconque des revendications précédentes, **caractérisé en ce que** plusieurs, de manière préférée 4, gorges de verrouillage (40) agencées à intervalles réguliers l'une de l'autre sur le pourtour de la première partie de palier de rotation (34) sont prévues au niveau de la première partie de palier de rotation (34).

6. Support (10) selon la revendication 5, **caractérisé en ce que** les éléments de verrouillage (46) présentent des parties de verrouillage (48) qui correspondent aux gorges de verrouillage (40) de telle manière que, dans la position de verrouillage, les parties de verrouillage (48) sont au moins partiellement rentrées dans les gorges de verrouillage.

7. Support (10) selon la revendication 6, **caractérisé en ce que** les gorges de verrouillage (40) et les parties de verrouillage (48) présentent un profil qui est réalisé de telle manière qu'une rotation de la première partie de palier de rotation (34) par rapport à la seconde partie de palier de rotation (36) engendre un déplacement des éléments de verrouillage (48) de la position de verrouillage jusqu'à la position de libération à l'encontre de la force de ressort du ressort annulaire (52) .

8. Support (10) selon l'une quelconque des revendications précédentes, **caractérisé en ce que** plusieurs, de manière préférée 2, éléments de verrouillage (46) agencés en miroir par rapport à l'axe de rotation (28) sont prévus.

9. Support (10) selon l'une quelconque des revendications précédentes, **caractérisé en ce que** plusieurs, de manière préférée 2, parties de guidage (50) destinées aux éléments de verrouillage (46) et agencées en miroir par rapport à l'axe de rotation (28) sont prévues au niveau de la seconde partie de palier de rotation (36).

10. Support (10) selon l'une quelconque des revendications précédentes, **caractérisé en ce que** les parties de guidage (50) sont conçues pour un guidage des éléments de verrouillage (46).

11. Support (10) selon l'une quelconque des revendications précédentes, **caractérisé en ce que** le palier de basculement (32) présente un axe de rotation de palier de basculement (33), dans lequel l'axe de rotation de palier de basculement (33) est agencé dans un plan (64) de la première et/ou de la seconde partie de palier de rotation (64, 66).

12. Dispositif de fixation (66) comprenant un support (10) selon l'une quelconque des revendications 1 à 11 et au moins un dispositif de montage (68) qui présente une douille de réception (70) conçue pour une fixation amovible de l'élément de fixation (14) du support (10).

13. Dispositif de fixation (66) selon la revendication 12, **caractérisé en ce que** le dispositif de montage (68) présente une base (74) avec un réceptacle (76) conçu pour un agencement au niveau d'un composant tubulaire et **en ce que** le dispositif de montage (68) présente un moyen de serrage (80) en forme de ceinture conçu pour une fixation par serrage du dispositif de montage (68) au niveau du composant tubulaire grâce à un serrage du composant tubulaire entre le réceptacle (76) et le moyen de serrage (80) .

14. Dispositif de fixation (66) selon la revendication 13, **caractérisé en ce que** le moyen de serrage (80) en forme de ceinture comprend une attache à crochets et boucles (86) et/ou un serre-câble (88) et/ou un excentrique de serrage (90).

15. Dispositif de fixation (66) selon la revendication 12, **caractérisé en ce que** le dispositif de montage (68) présente une ventouse (104) conçue pour une fixation au niveau d'une surface plane.

16. Dispositif de fixation (66) selon la revendication 12, **caractérisé en ce que** le dispositif de montage (68) est conçu pour une fixation au niveau d'un mur.

17. Dispositif de fixation (66) selon l'une quelconque des revendications 12 à 15, **caractérisé en ce qu'**une rallonge (98) est prévue, qui présente un élément de fixation (100) et une douille de réception (102) agencée à distance de l'élément de fixation (100) dans la direction axiale et agencée en particulier de manière axiale par rapport à l'élément de fixation (100).
